# EUROPEAN PATENT SPECIFICATION

(11) **EP 4 576 587 B1**
(45) Date of publication and mention of the grant of the patent: **25.02.2026**
(21) Application number: 23219091.8
(22) Date of filing: 21.12.2023
(51) Int. Cl.: H04B 1/00, H03M 1/66

(54) **RADIO FREQUENCY DIGITAL-TO-ANALOG CONVERTER**
HOCHFREQUENZ-DIGITAL-ANALOG-WANDLER
CONVERTISSEUR NUMÉRIQUE-ANALOGIQUE RADIOFRÉQUENCE

(43) Date of publication of application: 25.06.2025
(73) Proprietor: Stichting IMEC Nederland, 5656 AE Eindhoven (NL)
(72) Inventor: ALLEBES, Erwin, 6029 PZ Sterksel (NL); VAN DEN HEUVEL, Johan, 5663 RD Geldrop (NL)
(74) Representative: AWA Sweden AB

(56) References cited:
- US-A1- 2023 198 562
- US-B1- 9 825 643
- PISATI MATTEO ET AL: "A 243-mW 1.25-56-Gb/s Continuous Range PAM-4 42.5-dB IL ADC/DAC-Based Transceiver in 7-nm FinFET", IEEE JOURNAL OF SOLID-STATE CIRCUITS, IEEE, USA, vol. 55, no. 1, 1 January 2020 (2020-01-01), pages 6 - 18, XP011763147, ISSN: 0018-9200, [retrieved on 20191226], DOI: 10.1109/JSSC.2019.2936307
- GRUBER DANIEL ET AL: "A 12-b 16-GS/s RF-Sampling Capacitive DAC for Multi-Band Soft Radio Base-Station Applications With On-Chip Transmission-Line Matching Network in 16-nm FinFET", IEEE JOURNAL OF SOLID-STATE CIRCUITS, IEEE, USA, vol. 56, no. 12, 14 September 2021 (2021-09-14), pages 3655 - 3667, XP011889444, ISSN: 0018-9200, [retrieved on 20211122], DOI: 10.1109/JSSC.2021.3109489

## Description

### Technical field

The present description relates to the conversion of digital data to analog RF signals, and in particular to a radio frequency digital-to-analog converter (RFDAC) and a method of digital to analog RF signal conversion.

### Background

Wireless communications based on RF waves over both short and long distances have become more and more important to enable services, such as Wi-Fi and mobile communication. RFDACs for converting digital data into analog RF signals are widely utilized in wireless communication systems, for enabling transmission and reception of RF waves.

The regulatory bodies have different requirements to specify requirements, e.g., the maximum power or frequency range within which the device's emissions must remain, to ensure compliance with safety and interference regulations. One of the requirements of the regulatory bodies is the regulatory spectral mask. Thus, compliance with these requirements is crucial. However, the transmitters often face challenges in meeting these requirements due to inherent limitations in existing designs. For example, the stringent spectral requirement of the regulatory bodies for electronic devices, e.g., Ultra-Wideband (UWB) electronic devices may imply a steep RF filtering.

One current trend of the transmitter design is to use digital transmitters, e.g., digital polar transmitters, for advantages such as scalability, low power, less components, ease of calibration, and suitable for mass production. For example, the signal bandwidth is 499.2 MHz for UWB. To achieve the required spectral mask purity, a digital sample rate of 40 Gsps (Giga sample per second) is required. However, such a high digital sample rate is not only costly in terms of power and area, but also impractical in the current Complementary Metal Oxide Semiconductor (CMOS) technology.

One solution is to use a lower digital sample rate, such as 4 Gsps. However, it would typically cause huge spectral copies violating the regulatory spectral masks, make such solutions inappropriate or even useless.

Another solution is to use asynchronous design to achieve the required spectral purity. However, such designs are known to be complicated and time-consuming to calibrate and to manufacture in mass production.

Hence, there is a need for an RFDAC and a transmitter/transceiver for not only an improved regulatory spectral mask compliance, but also a lower power consumption, a reduced area and complexity, and a simplified calibration and mass production. The document US9825643B1 discloses related prior art.

### Summary

An objective of the present description is to provide an improved RFDAC, an improved transmitter/transceiver comprising the RFDAC, and an improved digital-to-analog converting method.

To be specific, an objective of the present description is to provide a RFDAC for converting a digital baseband signal into an analog RF signal for transmitting by an antenna, having not only an improved spectral performance, but also a lower power consumption, a reduced area and complexity, and a simplified calibration and mass production.

According to a first aspect, there is provided a radio frequency digital-to-analog converter, RFDAC, comprising:
a first stage converter, configured to receive a digital baseband signal and to generate a number N parallel data streams, each having a first resolution;
a serializer, configured to convert the number N parallel data streams into a serial data stream; and
a second stage converter, configured to receive the serial data stream, and to generate an analog up-converted radio frequency, RF, signal based on the serial data stream, wherein the analog up-converted RF signal has a second resolution;
wherein the first stage converter is a digital Finite Impulse Response, FIR, filter;
wherein the first stage converter is configured to be driven by a first clock signal having a first frequency F_{BB};
wherein the serializer is configured to be driven by a second clock signal having a second frequency Fₛ;
wherein the second stage converter comprises a number K slices in parallel, at least some of the number K slices are configured to each generate a respective portion of the analog up-converted RF signal based on a unique part of the serial data stream, such that the second resolution matches the first resolution;
wherein each slice of the number K slices comprises at least one analog delay element for shaping the respective portion of the analog up-converted RF signal;
wherein F_{BB}= Fₛ / N;
wherein N is an integer, and N >= 1; and
wherein K is an integer, and K >= 2, preferably K >= 4.

The first frequency F_{BB} may represent a baseband speed or a symbol clock speed. The second frequency Fs may represent a higher data speed such that the number N parallel data streams of the first frequency F_{BB} can be serialised to a serial data stream of the higher frequency Fₛ ( Fₛ = N x F_{BB}).

The serializer may comprise a switch configured to: 1) operatively connect to each of the number N parallel data streams , one at a time, sequentially from a first until a last data stream of the number N parallel data streams, to receive data from the number N parallel streams of data sequentially; 2) after connected to the last stream of data, loop back to connect to the first data stream again; and 3) repeat 1) and 2), to convert the number N parallel data streams of a lower speed into a serial data stream of a higher speed.

The serializer may be configured to convert the number N parallel streams of data into one serial data stream.

The serializer may comprise a multiplexer.

The first stage converter and the serializer may be implemented as a single module.

When N = 1, since there is a single data stream feed into the serializer, the output and input of the serializer may be the same.

The second stage converter may be configured to be driven by the second clock signal having the second frequency Fₛ, or a different clock signal having the second frequency Fₛ.

The second stage converter may be configured to generate the analog up-converted RF signal by mixing with an RF carrier.

The analog up-converted RF signal may be up-converted by a mixer mixing with an RF carrier. Thus, the output signal of the second stage converter is not an I/Q signal for transmitting by a I/Q transmitter.

A slice of a converter may refer to a portion or subsection of the converter, which may perform a part of the overall functionality of the converter, and collectively contribute to the conversion process.

Each slice may convert a part of the serial data stream into a part of the analog up-converted RF. The outputs of the number K slices may be summed or combined to form the analog up-converted RF signal.

Each slice may comprise multiple different components, such as delay elements, amplifiers, mixers, etc. These components work together to convert a digital input into an analog up-converted RF output.

Having multiple slices may allow for parallel conversion, which can increase the overall conversion speed and performance. The number K slices can be connected or configured in various ways depending on the specific design and requirements of the RFDAC.

N may be equal or larger than 2. That is, the first stage converter may generate at least two parallel data streams.

The first stage converter may comprise a number N modules in parallel, each configured to generate a respective one of the number N parallel data streams.

The number N parallel data streams may comprise data encoded by binary or thermometric coding.

The second resolution may be equal to or different from the first resolution.

The term "resolution" is used to define the level of detail of, e.g., an image or a signal. The higher the resolution, the more details are present, resulting in more detailed images or signals. In the present application, the term "resolution" is used to define the level of detail of a signal.

The first resolution may be characterized by the number of bits of data of the number N parallel data streams. For example, when the data is 5-bits, the first resolution of the parallel data stream may be 32 (2⁵).

The second resolution may be characterized by the number K, i.e. the number of slices, i.e. the number of portions for forming the analog up-converted RF signal. For example, when K is selected to be 32 and all 32 slices together generate the analog up-converted RF signal, the analog up-converted RF signal has 32 portions, e.g., 32 amplitude steps. Thus, it is considered that the second resolution (the 32 portions) matches the first resolution (5-bits).

Each slice of the number K slices may have a respective weighting value for scaling a respective amplitude step of the respective portion of the analog up-converted RF signal.

The weighting values may be LSB (Least Significant Bit) thermos weighted, binary weighted, or LSB +MSB (Most Significant Bit) weighted (row-column), etc. Different weighting method would not change the second resolution.

Each slice of the at least some of the number K slices may be configured to generate the respective portion of the analog up-converted RF signal having a respective amplitude step. The analog up-converted RF signal may be formed by combining the outputs of the at least some of the number K slices.

The amplitude step of the respective portion of the analog up-converted RF signal may be a maximum amplitude difference of said portion of the analog up-converted RF signal.

The amplitude step may be one least significant bit, LSB, step of the up-converted RF analog signal.

The at least one analog delay element of the slice may provide an interpolation within the amplitude range of the amplitude step. In other words, instead of having only the number K of amplitude steps, the analog delay elements further refine the shape of the up-converted RF analog signal by interpolation. This may further improve spectral performance.

The at least one analog delay element may be tunable or programmable.

A tunable analog delay element may be an analog device or circuit that introduces a controllable delay to an input signal by utilizing analog components. Since it allows an adjustable delay time, it is widely used in radar systems, telecommunication systems, and various electronic applications where precise control over signal delays is essential.

A programmable analog delay element may be a more advanced version of the tunable delay element. It offers additional features and capabilities by allowing a user to program the delay time, e.g., remotely or through a control interface. The programmable analog delay element typically comprises a microcontroller to enable as precise and convenient control over delay settings.

This is advantageous as an accurate, dynamic, and flexible control over the delay parameters can be achieved.

Any two slices of the number K slices may have a same number or different numbers of analog delay elements.

The numbers of delay elements of the number K slices may be different from each other. This is advantageous as the spectral copies may be spread around.

Any two analog delay elements of each slice may be same or different.

Randomly changing a selected slice from slices with a different set of analog delay parameters for the analog delay elements may further improve the spectral performance and improve the performance in view of process, voltage and temperature variations.

Any of the K slices that have a different number of analog delay cells and/or any of the K slices that have different analog delay elements may be randomly selected during operation.

Randomly changing a selected slice from slices with a different number of analog delay elements may further improve the spectral performance and improve the performance in view of process, voltage and temperature variations.

Each analog delay element of the number K slices may have a respective weighting value for an amplitude scaling.

By providing a weighting value for each analog delay element, the RFDAC can be more flexible. This is also advantageous for shaping the analog signal.

Each slice of the number K slices may comprise a delay locked loop comprising the at least one analog delay element. The delay locked loop may be configured to synchronize said slice to the second clock signal.

The slice may be calibrated to synchronize with both the rising edge and the falling edge of said signal.

Each slice may comprise any of:
a switched-capacitor digital-to-analog converter, sc-DAC,
a switched-capacitor amplifier, and
a Zero Order Hold, ZOH, analog FIR filter.

The slice may be implemented by a combination of a digital-to-analog converter (DAC) and a power amplifier (PA).

According to a second aspect, there is provided a radio frequency transmitter or transceiver, comprising an RFDAC according to the first aspect, configured to receive the digital baseband signal and to generate the analog up-converted RF signal for transmitting.

According to a third aspect, there is provided a digital-to-analog converting method, comprising:
receiving a digital baseband signal and generating a number N parallel data streams each having a first resolution, by a first stage converter;
converting the number N parallel data streams into a serial data stream, by a serializer; and
receiving the serial data stream, and generating an analog up-converted RF signal based on the serial data stream, by a second stage converter, wherein the analog up-converted RF signal has a second resolution;
wherein the first stage converter is a digital Finite Impulse Response, FIR, filter;
wherein the first stage converter is configured to be driven by a first clock signal having a first frequency F_{BB};
wherein the serializer is configured to be driven by a second clock signal having a second frequency Fₛ;
wherein the second stage converter comprises a number K slices in parallel, the method comprising:
   at least some of the number K slices each generating a respective portion of the analog up-converted RF signal based on a unique part of the serial data stream, such that the second resolution matches the first resolution;
   wherein each slice of the number K slices comprises at least one analog delay element, the method comprising:
      the at least one analog delay element shaping the respective portion of the analog up-converted RF signal;
      wherein F_{BB}= Fₛ / N;
      wherein N is an integer, and N >= 1; and
      wherein K is an integer, and K >= 2, preferably K >= 4.

The second and third aspects may generally present the same or corresponding advantages as the first aspect.

### Brief description of the drawings

The above, as well as additional objects, features, and advantages of the present description, will be better understood through the following illustrative and non-limiting detailed description, with reference to the appended drawings. In the drawings like reference numerals will be used for like elements unless stated otherwise.
Fig. 1 is a schematical view of an example RFDAC.
Figs 2A- 2B are two examples of a first stage converter.
Figs 3A- 3B are two examples of a serializer.
Fig. 4 illustrates operation principles of a serializer.
Fig. 5 is a schematical view of an example second stage converter.
Figs 6A- 6B illustrate different weighting schemes for slices of a second stage converter.

### Detailed description

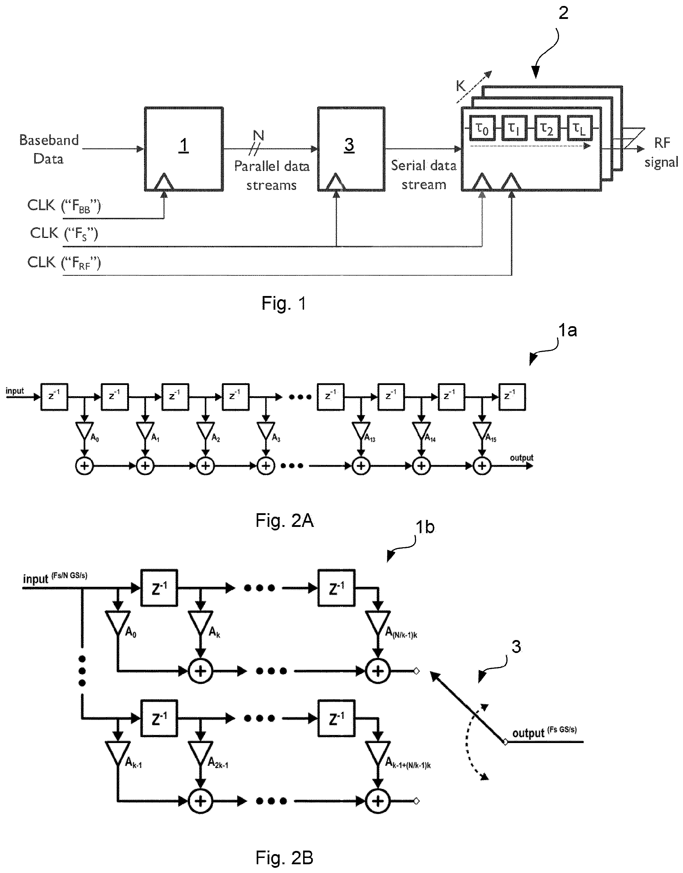

In connection with Fig. 1, an example RFDAC will be discussed in detail.

The RFDAC comprises a first stage converter 1, a second stage converter 2, and a serializer 3 connecting to the first and second stage converter 1, 2.

An RF transmitter or transceiver may comprise the RFDAC for receiving a digital baseband signal and to generate an analog up-converted RF signal for transmitting by an antenna.

The first stage converter 1 is a digital Finite Impulse Response, FIR, filter. The first stage converter 1 is configured to receive a digital baseband signal as an input signal, and to generate a number N parallel data streams, each having a first resolution. N is an integer, and N >= 1.

The first stage converter 1 is configured to be driven by a first clock signal having a first frequency F_{BB}.

The first stage converter 1 is a digital Finite Impulse Response, FIR, filter.

Since the conversion performed by the first stage converter 1 is digital, which is fully configurable, the spectral performance of the RFDAC can be improved, and the inter-symbol interference (ISI) can be suppressed.

The serializer 3 is configured to receive and convert the number N parallel data streams into a serial data stream.

As shown in Fig. 1, the serializer 3 may be configured to convert the number N parallel streams of data into one serial data stream.

The serializer 3 may comprise a multiplexer or a switch.

The serializer 3 is configured to be driven by a second clock signal having a second frequency Fₛ, wherein F_{BB}= Fₛ / N.

By using the serializer 3, multiple parallel slow sample rate data streams can be combined into one or more high speed data streams.

The first stage converter 1 and the serializer 3 may be implemented as a single module, driven by the first clock signal.

When N = 1, since there is a single data stream feed into the serializer 3, the output and input of the serializer 3 may be the same.

The number N parallel data streams may comprise data encoded by binary or thermometric coding.

The second stage converter 2 is configured to receive the serial data stream, and to generate an analog up-converted radio frequency, RF, signal based on the serial data stream. The analog up-converted RF signal has a second resolution.

The second stage converter 2 comprises a number K slices in parallel, at least some of the number K slices are configured to each generate a respective portion of the analog up-converted RF signal based on a unique part of the serial data stream, such that the second resolution matches the first resolution.

Each slice of the number K slices comprises at least one analog delay element for shaping the respective portion of the analog up-converted RF signal. K is an integer, and K >= 2, preferably K >= 4.

A slice of a converter may refer to a portion or subsection of the converter, which may perform a part of the overall functionality of the converter, and collectively contribute to the conversion process.

Each slice may convert a part of the serial data stream into a part of the analog up-converted RF. The outputs of the number K slices may be summed or combined to form the analog up-converted RF signal.

Thus, the slices may be considered to contribute to the resolution of the analog up-converted RF signal. The higher the number of the slices for forming the analog up-converted RF signal, the higher the resolution of the analog up-converted RF signal.

Each slice may comprise multiple different components, such as one or more analog delay elements, amplifiers, mixers, etc. These components work together to convert a digital input into an analog up-converted RF output.

Having multiple slices may also allow for parallel conversion, which can increase the overall conversion speed and performance. The number K slices can be connected or configured in various ways depending on the specific design and requirements of the RFDAC.

The second stage converter 2 may be configured to be driven by the second clock signal having the second frequency Fₛ, or a different clock signal having the second frequency Fₛ.

The second stage converter may be configured to generate the analog up-converted RF signal by mixing with an RF carrier. The analog up-converted RF signal may be up-converted by a mixer (not shown) mixing with an RF carrier. Thus, the output signal of the second stage converter 2 is not an I/Q signal for transmitting by a I/Q transmitter.

As shown in Fig, 1, the second stage converter 2 may receive a RF clock signal having a frequency F_{RF}.

The at least one analog delay element may be tunable or programmable.

A tunable analog delay element may be an analog device or circuit that introduces a controllable delay to an input signal by utilizing analog components. Since it allows an adjustable delay time, it is widely used in radar systems, telecommunication systems, and various electronic applications where precise control over signal delays is essential.

A programmable analog delay element may be a more advanced version of the tunable delay element. It can offer additional features and capabilities by allowing a user to program the delay time, e.g., remotely or through a control interface. The programmable analog delay element typically comprises a microcontroller to enable a precise and convenient control over the delay settings.

This is advantageous as an accurate, dynamic, and flexible control over the delay parameters can be achieved.

The second resolution may be equal to or different from the first resolution.

The term "resolution" is used to define the level of detail, e.g., of an image or of a signal. The higher the resolution, the more details are present, resulting in more detailed images or signals. In the present application, the term "resolution" is used to define the level of detail of a signal.

The first resolution may be characterized by the number of bits of data of the number N parallel data streams. For example, when the data is 5-bits, the first resolution of the parallel data stream may be 32 (2⁵). The resolution of the serial data stream may be different from the first resolution of the parallel data stream, as the serializer may skip one or more bits of the data of the parallel data streams.

The second resolution may be characterized by the number K, i.e. the number of slices, i.e. the number of portions for forming the analog up-converted RF signal.

For example, when K is selected to be 32 and all 32 slices respectively generate 32 portions for forming the analog up-converted RF signal, the analog up-converted RF signal has 32 amplitude steps (both amplitude increasing steps and decreasing steps). Thus, it is considered that the second resolution (the 32 portions) of the analog up-converted RF signal matches the first resolution (5-bits).

However, the first and second resolution do not need to be equal. For example, when the serializer 3 skips one bit of the parallel data streams (e.g., 5-bits), the serial data stream input to the second stage converter 2 is of e.g., 4-bits (5-1). Even if K is 32 and only 16 of the 32 slices are used to respectively generate 16 portions for forming the analog up-converted RF signa, it is still considered that the second resolution (the 16 amplitude steps) matches the first resolution (5-bits).

In other words, the number K is selected such that the resolution of the output analog up-converted RF signal matches the resolution of the input parallel data streams in a way that no information or very little amount of information is lost during the digital-to-analog conversion.

In Fig. 1, one example slice comprises a number L analog delay elements. L is an integer, and L >= 1.

The pulse shape of the analog up-converted RF signal to be transmitted is important for its spectral performance. As any discontinuity of the pulse shape of a signal in the time domain would introduce unwanted noises in the frequency domain.

The analog delay elements of the slices may refine the pulse shape of the analog up-converted RF signal for improving spectral performance.

The analog delay elements may refine the pulse shape of the analog up-converted RF signal by interpolation. Interpolation may refer to a method of creating new data points based on a set of known data points to refine or smoothen a curve based on the set of known data points. One goal of interpolation is to create intermediate values between provided values. Examples of interpolation may include linear interpolation, polynomial interpolation, etc.

The present description also includes a digital-to-analog converting method. The digital-to-analog converting method can be implemented by the RFDAC of the present description.

The digital-to-analog converting method comprises:
receiving a digital baseband signal and generating a number N parallel data streams each having a first resolution, by a first stage converter 1;
converting the number N parallel data streams into a serial data stream, by a serializer 3; and
receiving the serial data stream, and generating an analog up-converted RF signal based on the serial data stream, by a second stage converter 2, wherein the analog up-converted RF signal has a second resolution;
wherein the first stage converter 1 is a digital Finite Impulse Response, FIR, filter;
wherein the first stage converter 1 is configured to be driven by a first clock signal having a first frequency F_{BB};
wherein the serializer 3 is configured to be driven by a second clock signal having a second frequency Fₛ ;
wherein the second stage converter 2 comprises a number K slices in parallel, the method comprising:
   at least some of the number K slices each generating a respective portion of the analog up-converted RF signal based on a unique part of the serial data stream, such that the second resolution matches the first resolution;
   wherein each slice of the number K slices comprises at least one analog delay element, the method comprising:
      the at least one analog delay element shaping the respective portion of the analog up-converted RF signal;
      wherein F_{BB}= Fₛ / N; N is an integer, and N >= 1; and K is an integer, and K >= 2, preferably K >= 4.

In connection with Figs 2A- 2B, the first stage converter will be discussed in detail.

Fig. 2A illustrates an example first stage converter 1a when N =1.

The first stage converter 1a is a digital Finite Impulse Response, FIR, filter, configured to receive a digital baseband signal as input and to generate one data stream having a first resolution as output.

A digital FIR filter is a type of digital filter used to process digital signals. It is called "Finite Impulse Response" because the filter's response to an impulse input is finite in duration. An FIR filter operates by convolving the input signal with a finite and usually symmetric sequence of filter coefficients, often called the impulse response. These coefficients determine the overall frequency response of the FIR filter.

Using a digital FIR filter is advantageous as it can be easily designed to provide a clean output signal without introducing any distortion in the time domain, and to offer a better control over the frequency response characteristics.

In typical implementation, N >= 2. Fig. 2B illustrates an example first stage converter 1b when N >= 2.

As shown in Fig. 2B, the first stage converter 1b may comprise a number N modules in parallel, each configured to receive the same digital baseband signal, and to generate a respective one of the number N parallel data streams.

The serializer 3 in Fig, 2B is illustrated as a switch.

The switch may be configured to operatively connect to one of the number N parallel data streams at a time, from a first until a last data stream of the number N parallel data streams, to sequentially receive data from the number N parallel data streams. After connected to the last data stream, the switch may loop back to connect to the first data stream, and operatively connect from the first until the last data stream again, to sequentially receive data from the number N parallel data streams. Thus, the switch may perform the parallel to serial conversion by repeatedly sweeping over the number N parallel data streams.

In Fig. 2B, the number k refers to a depth of the digital FIR filter, which is different the number K representing the number of slices of the second stage converter 2.

Figs 2A- 2B are only two examples of the first stage converter 1. The first stage converter 1 may be implemented differently.

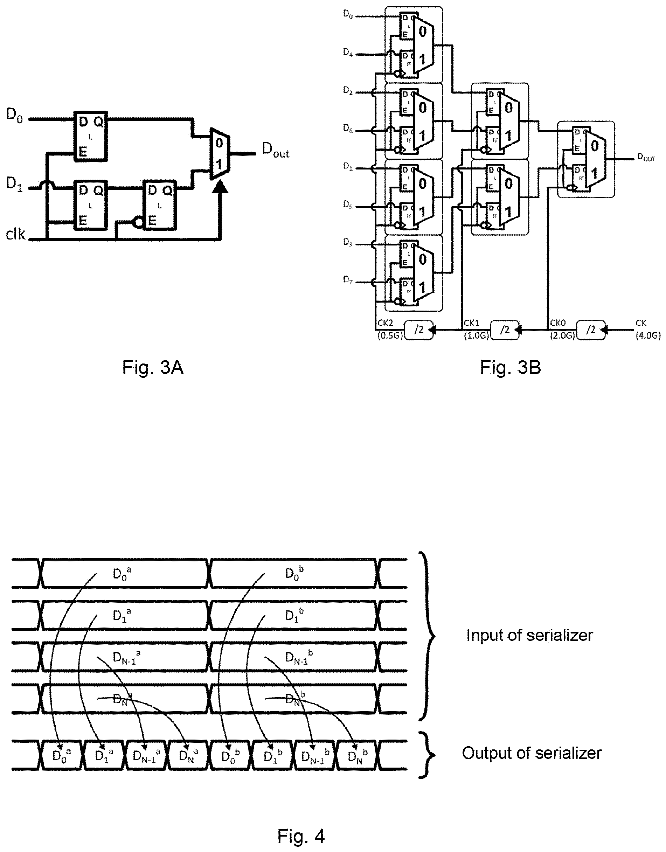

In connection with Figs 3A- 3B, the serializer 3 will be discussed in detail.

Fig. 3A is a schematical view of a basic 2:1 serializer for serializing two parallel data inputs into one serial data output.

In Fig. 3A, one latch is provided for the data input D₀, and two latches are provided for the data input D₁. A multiplexer is provided for selecting from the latched data of D₀ and D₁. The three latches and the multiplexer are controlled by a same clock signal clk.

Thus, by using latches and a multiplexer, the two parallel data inputs D₀ and D₁ can be serialized into one serial data output.

The 2:1 serializer of Fig. 3A can be used as a basic unit for building a serializer for serializing more than two parallel data inputs.

Fig. 3B is a schematical view of an 8:1 serializer for serializing eight parallel data inputs into one serial data output by using seven 2:1 serializers of Fig. 3A.

In a first level, four serializers are provided in parallel for respectively serializing two of the eight parallel data inputs D₀ to D₇. The first clock signal for driving these four serializers has a frequency CK2 (e.g., 0.5 GHz).

In a second level, two serializers are provided in parallel for respectively serializing four parallel data inputs (i.e. the outputs of the four serializers of the first level). The second clock signal for driving these two serializers has a frequency CK1 (e.g., 1 GHz), CK1 = CK2 x 2.

In a third level, one serializer is provided for serializing two parallel data inputs (i.e. the outputs of the two serializers of the second level). The third clock signal for driving these two serializers has a frequency CK0 (e.g., 2 GHz), CK0 = CK1 x 2.

The final output serial data stream has a frequency of CK, CK = CK0 x 2.

As shown in Fig. 3B, by cascading the 2:1 serializer of Fig. 3A, the 8:1 serializer of a higher serialization ratio can be achieved.

Further, the frequency of the final output serialized data steam of Fig. 3B (e.g., 4 GHz) is eight times of the frequency of the input parallel data D₀-D₇ (e.g., 0.5 GHz).

In connection with Fig. 4, operation principles of the serializer 3 will be discussed in detail.

Fig. 4 illustrates the number N parallel data streams D₀, D₁, D_{N-1}, D_{N}, which are input to the 4: 1 serializer (not shown). In this example, N = 4.

The serializer 3 using a speed higher than the data speed of the number N parallel data streams D₀, D₁, D_{N-1}, D_{N}, to fetch data from each of the number N parallel data streams D₀, D₁, D_{N-1}, D_{N}, and combine the fetched into a serial data stream in a sequential order. Thus, by increasing the data speed (frequency), the number N parallel data streams D₀, D₁, D_{N-1}, D_{N} can be combined into a serial data stream without losing any information.

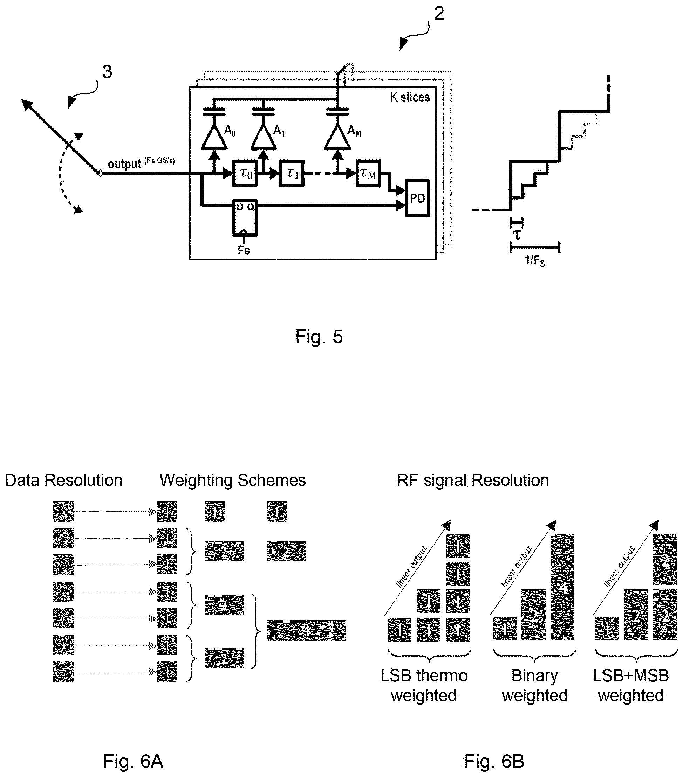

In connection with Fig. 5, the second stage converter 2 will be discussed in detail.

Each slice of the at least some of the number K slices may be configured to generate the respective portion of the analog up-converted RF signal having a respective amplitude step.

The analog up-converted RF signal may be formed by combining the outputs of the at least some of the number K slices.

The analog up-converted RF signal may be formed by combining the outputs of the number K slices.

The amplitude step of the respective portion of the analog up-converted RF signal may be a maximum amplitude difference of said portion of the analog up-converted RF signal.

The amplitude step may be one least significant bit, LSB, step of the up-converted RF analog signal.

One slice of the second stage converter 2 of Fig. 5 comprises multiple analog delay elements connected in series. Thus, each of the analog delay elements may individually delay the input signal entering said analog delay element for a delay time. Further, each analog delay element is provided with an amplifier for increasing the amplitude of the input signal of said amplifier. All the delayed signals of a single slice may be summed together to form a portion of the analog up-converted RF signal. In other words, the analog delay elements and the amplifiers will work together to define the pulse shape (delay time and amplitude) of the portion of the analog up-converted RF signal for transmitting.

As shown in Fig. 5, the amplitude step of this slice may be refined into multiple tiny steps each having a duration of the delay time of the analog delay elements (assuming that the delay time is the same for each analog delay element).

Thus, the at least one analog delay element of the slice may provide an interpolation within the amplitude range of the amplitude step of said slice. In other words, instead of having number K of amplitude steps, the analog delay elements further refine the shape of the up-converted RF analog signal by interpolation.

Any two analog delay elements of each slice may be same or different.

Two same analog delay elements may have the same delay parameters such that they will cause the same delay time. In contrast, two different analog delay elements may have different delay parameters such that they will cause different delays in time.

Using different analog delay elements within one slice and/or between different slices may also improve spectral performance. Randomly changing a selected slice from slices with a different set of analog delay parameters for the analog delay elements may further improve the spectral performance and improve the performance in view of process, voltage and temperature variations.

Each analog delay element of the number K slices may have a respective weighting value for an amplitude scaling.

The weighting values for the analog delay elements of one slice may be e.g., 1, 2, 4, 8, 16 ... By providing a weighting value for each analog delay element, the RFDAC can be more flexible. This is also advantageous for shaping the analog signal.

The weighting value can be realized by the amplifier. The amplifier may comprise an inverter connected with a capacitor in series, as shown in Fig. 5.

The weighting values for any two analog delay elements of each slice may be the same or different.

Each slice of the number K slices may comprise a delay locked loop comprising the at least one analog delay element. The delay locked loop may be configured to synchronize said slice to a signal, e.g., the second clock signal.

The slice may be calibrated to synchronize with both the rising edge and the falling edge of said signal.

Any two slices of the number K slices may have a same number or different numbers of analog delay elements. For example, the number K slices may each comprise a same number L of analog delay element. For example, the number K slices may comprise different numbers of analog delay element each.

For example, any of the K slices that have a different number of analog delay cells and/or any of the K slices that have different analog delay elements are randomly selected during operation. Randomly changing a selected slice from slices with a different number of analog delay elements may further improve the spectral performance and improve the performance in view of process, voltage and temperature variations.

Each slice of the number K slices may comprise a delay locked loop comprising the at least one analog delay element. The delay locked loop may be configured to synchronize said slice to the second clock signal.

Each slice may be calibrated to synchronize with any of the rising edge and the falling edge of the second clock signal.

The slice may be implemented by a combination of a digital-to-analog converter (DAC) and a power amplifier (PA).

Each slice may comprise any of:
a switched-capacitor digital-to-analog converter, sc-DAC,
a switched-capacitor amplifier, and
a Zero Order Hold, ZOH, analog FIR filter.

In connection with Figs 6A- 6B, different weighting schemes for the number K slices will be discussed in detail.

Each slice of the number K slices may have a respective weighting value for scaling a respective amplitude step of the respective portion of the analog up-converted RF signal.

In Fig. 6A, three different weighting schemes are provided as examples. For example, the N parallel data streams each comprises data of 3-bit, and K = 7.

A first example is the LSB thermos weighted, e.g., 1, 1, 1, 1, 1, 1, 1.

A second example is the binary weighted, e.g., 1, 2, 4.

A third example is the LSB +MSB weighted (row-column), e.g., 1, 2, 2, 2.

From Fig. 6B, the second resolution remains unchanged no matter which weighting scheme is used.

By using the RFDAC for converting the digital baseband signal to the analog up-converted RF signal, the noises can be suppressed over the spectrum. Further, by using the number K slices comprising at least one analog delay element for shaping the respective portion of the analog up-converted RF signal, the spectral performance can be further improved. Moreover, the RFDAC can be easily calibrated and manufactured.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A radio frequency digital-to-analog converter, RFDAC, comprising:
a first stage converter, configured to receive a digital baseband signal and to generate a number N parallel data streams, each having a first resolution;
a serializer, configured to convert the number N parallel data streams into a serial data stream; and
a second stage converter, configured to receive the serial data stream, and to generate an analog up-converted radio frequency, RF, signal based on the serial data stream, wherein the analog up-converted RF signal has a second resolution;
wherein the first stage converter is a digital Finite Impulse Response, FIR, filter;
wherein the first stage converter is configured to be driven by a first clock signal having a first frequency F_{BB};
wherein the serializer is configured to be driven by a second clock signal having a second frequency Fₛ;
wherein the second stage converter comprises a number K slices in parallel, at least some of the number K slices are configured to each generate a respective portion of the analog up-converted RF signal based on a unique part of the serial data stream, such that the second resolution matches the first resolution;
wherein each slice of the number K slices comprises at least one analog delay element for shaping the respective portion of the analog up-converted RF signal;
wherein F_{BB}= Fₛ / N;
wherein N is an integer, and N >= 1; and
wherein K is an integer, and K >= 2, preferably K >= 4.

2. The RFDAC according to claim 1, wherein N >= 2.

3. The RFDAC according to any one of claims 1- 2, wherein the first stage converter comprises a number N modules in parallel, each configured to generate a respective one of the number N parallel data streams.

4. The RFDAC according to any one of claims 1- 3, wherein the number N parallel data streams comprise data encoded by binary or thermometric coding.

5. The RFDAC according to any one of claims 1- 4, wherein the second resolution is equal to or different from the first resolution.

6. The RFDAC according to any of claims 1- 5, wherein each slice of the number K slices has a respective weighting value for scaling a respective amplitude step of the respective portion of the analog up-converted RF signal.

7. The RFDAC according to any of claims 1- 6, wherein each slice of the at least some of the number K slices is configured to generate the respective portion of the analog up-converted RF signal having a respective amplitude step;
wherein the analog up-converted RF signal is formed by combining the outputs of the at least some of the number K slices.

8. The RFDAC according to any of claims 1- 7, wherein the at least one analog delay element is tunable or programmable.

9. The RFDAC according to any of claims 1- 8, wherein any two slices of the number K slices have a same number or different numbers of analog delay elements and wherein any two analog delay elements of each slice are same or different.

10. The RFDAC according to claim 9, wherein any of the K slices that have a different number of analog delay cells and/or any of the K slices that have different analog delay elements are randomly selected during operation.

11. The RFDAC according to any of claims 1- 10, wherein each analog delay element of the number K slices has a respective weighting value for an amplitude scaling.

12. The RFDAC according to any of claims 1- 11, wherein each slice of the number K slices comprises a delay locked loop comprising the at least one analog delay element;
wherein the delay locked loop is configured to synchronize said slice to the second clock signal.

13. The RFDAC according to any of claims 1- 12, wherein each slice comprises any of:
a switched-capacitor digital-to-analog converter, sc-DAC,
a switched-capacitor amplifier, and
a Zero Order Hold, ZOH, analog FIR filter.

14. A radio frequency transmitter or transceiver, comprising an RFDAC according to any of claims 1- 13, configured to receive the digital baseband signal and to generate the analog up-converted RF signal for transmitting.

15. A digital-to-analog converting method, comprising:
receiving a digital baseband signal and generating a number N parallel data streams each having a first resolution, by a first stage converter;
converting the number N parallel data streams into a serial data stream, by a serializer; and
receiving the serial data stream, and generating an analog up-converted RF signal based on the serial data stream, by a second stage converter, wherein the analog up-converted RF signal has a second resolution;
wherein the first stage converter is a digital Finite Impulse Response, FIR, filter;
wherein the first stage converter is configured to be driven by a first clock signal having a first frequency F_{BB};
wherein the serializer is configured to be driven by a second clock signal having a second frequency Fₛ;
wherein the second stage converter comprises a number K slices in parallel, the method comprising:
at least some of the number K slices each generating a respective portion of the analog up-converted RF signal based on a unique part of the serial data stream, such that the second resolution matches the first resolution;
wherein each slice of the number K slices comprises at least one analog delay element, the method comprising:
the at least one analog delay element shaping the respective portion of the analog up-converted RF signal;
wherein F_{BB}= Fₛ / N;
wherein N is an integer, and N >= 1; and
wherein K is an integer, and K >= 2, preferably K >= 4.

## Patentansprüche

1. Hochfrequenz-Digital-Analog-Wandler, RFDAC, umfassend:
einen Wandler erster Stufe, der dazu konfiguriert ist, ein digitales Basisbandsignal zu empfangen und eine Anzahl von N parallelen Datenströmen zu erzeugen, die jeweils eine erste Auflösung aufweisen;
einen Serialisierer, der dazu konfiguriert ist, die Anzahl von N parallelen Datenströmen in einen seriellen Datenstrom umzuwandeln; und
einen Wandler zweiter Stufe, der dazu konfiguriert ist, den seriellen Datenstrom zu empfangen, und ein analoges aufwärtsgewandeltes Hochfrequenz-, RF, Signal basierend auf dem seriellen Datenstrom zu erzeugen, wobei das analoge aufwärtsgewandelte RF-Signal eine zweite Auflösung aufweist;
wobei der Wandler erster Stufe ein digitales Filter mit endlicher Impulsantwort, FIR, ist;
wobei der Wandler erster Stufe dazu konfiguriert ist, von einem ersten Taktsignal angesteuert zu werden, das eine erste Frequenz F_{BB} aufweist;
wobei der Serialisierer dazu konfiguriert ist, von einem zweiten Taktsignal angesteuert zu werden, das eine zweite Frequenz Fₛ aufweist;
wobei der Wandler zweiter Stufe eine Anzahl von K parallelen Segmenten umfasst, wobei mindestens einige der Anzahl von K Segmenten dazu konfiguriert sind, jeweils einen jeweiligen Abschnitt des analogen aufwärtsgewandelten RF-Signals basierend auf einem eindeutigen Teil des seriellen Datenstroms zu erzeugen, so dass die zweite Auflösung mit der ersten Auflösung übereinstimmt;
wobei jedes Segment der Anzahl von K Segmenten mindestens ein analoges Verzögerungselement zum Formgeben des jeweiligen Abschnitts des analogen aufwärtsgewandelten RF-Signals umfasst;
wobei F_{BB} = Fₛ / N;
wobei N eine Ganzzahl ist, und N >= 1; und
wobei K eine Ganzzahl ist, und K >= 2, bevorzugt K >= 4.

2. RFDAC nach Anspruch 1, wobei N >= 2.

3. RFDAC nach einem der Ansprüche 1 bis 2, wobei der Wandler erster Stufe eine Anzahl von N parallelen Modulen umfasst, die jeweils dazu konfiguriert sind, einen jeweiligen der Anzahl von N parallelen Datenströmen zu erzeugen.

4. RFDAC nach einem der Ansprüche 1 bis 3, wobei die Anzahl von N parallelen Datenströmen Daten umfasst, die durch binäre oder thermometrische Codierung codiert werden.

5. RFDAC nach einem der Ansprüche 1 bis 4, wobei die zweite Auflösung gleich oder anders als die erste Auflösung ist.

6. RFDAC nach einem der Ansprüche 1 bis 5, wobei jedes Segment der Anzahl von K Segmenten einen jeweiligen Gewichtungswert zum Skalieren einer jeweiligen Amplitudenstufe des jeweiligen Abschnitts des analogen aufwärtsgewandelten RF-Signals aufweist.

7. RFDAC nach einem der Ansprüche 1 bis 6, wobei jedes Segment der mindestens einigen der Anzahl von K Segmenten dazu konfiguriert ist, den jeweiligen Abschnitt des analogen aufwärtsgewandelten RF-Signals zu erzeugen, das eine jeweilige Amplitudenstufe aufweist;
wobei das analoge aufwärtsgewandelte RF-Signal durch Kombinieren der Ausgaben der mindestens einigen der Anzahl von K Segmenten gebildet wird.

8. RFDAC nach einem der Ansprüche 1 bis 7, wobei das mindestens eine analoge Verzögerungselement abstimmbar oder programmierbar ist.

9. RFDAC nach einem der Ansprüche 1 bis 8, wobei zwei beliebige Segmente der Anzahl von K Segmenten eine gleiche Anzahl oder unterschiedliche Anzahlen von analogen Verzögerungselementen aufweisen, und wobei zwei beliebige analoge Verzögerungselemente jedes Segments gleich oder unterschiedlich sind.

10. RFDAC nach Anspruch 9, wobei beliebige der K Segmente, die eine andere Anzahl von analogen Verzögerungszellen aufweisen, und/oder beliebige der K Segmente, die unterschiedliche analoge Verzögerungselemente aufweisen, während des Betriebs zufällig ausgewählt werden.

11. RFDAC nach einem der Ansprüche 1 bis 10, wobei jedes analoge Verzögerungselement der Anzahl von K Segmenten einen jeweiligen Gewichtungswert für eine Amplitudenskalierung aufweist.

12. RFDAC nach einem der Ansprüche 1 bis 11, wobei jedes Segment der Anzahl von K Segmenten einen Verzögerungsregelkreis umfasst, der das mindestens eine analoge Verzögerungselement umfasst;
wobei der Verzögerungsregelkreis dazu konfiguriert ist, das Segment mit dem zweiten Taktsignal zu synchronisieren.

13. RFDAC nach einem der Ansprüche 1 bis 12, wobei jedes Segment eines umfasst von:
einem Digital-Analog-Wandler mit Schaltkondensator, sc-DAC,
einem Verstärker mit Schaltkondensator, und
einem analogen FIR-Filter mit Haltezeit nullter Ordnung, ZOH.

14. Hochfrequenz-Sender oder -Transceiver, umfassend einen RFDAC nach einem der Ansprüche 1 bis 13, der dazu konfiguriert ist, das digitale Basisbandsignal zu empfangen und das analoge aufwärtsgewandelte RF-Signal zum Senden zu erzeugen.

15. Digital-Analog-Umwandlungsverfahren, umfassend:
Empfangen eines digitalen Basisbandsignals und Erzeugen einer Anzahl von N parallelen Datenströmen, die jeweils eine erste Auflösung aufweisen, durch einen Wandler erster Stufe;
Umwandeln der Anzahl von N parallelen Datenströmen in einen seriellen Datenstrom, durch einen Serialisierer; und
Empfangen des seriellen Datenstroms und Erzeugen eines analogen aufwärtsgewandelten RF-Signals basierend auf dem seriellen Datenstrom, durch einen Wandler zweiter Stufe, wobei das analoge aufwärtsgewandelte RF-Signal eine zweite Auflösung aufweist;
wobei der Wandler erster Stufe ein digitales Filter mit endlicher Impulsantwort, FIR, ist;
wobei der Wandler erster Stufe dazu konfiguriert ist, von einem ersten Taktsignal angesteuert zu werden, das eine erste Frequenz F_{BB} aufweist;
wobei der Serialisierer dazu konfiguriert ist, von einem zweiten Taktsignal angesteuert zu werden, das eine zweite Frequenz Fₛ aufweist;
wobei der Wandler zweiter Stufe eine Anzahl von K parallelen Segmenten umfasst, wobei das Verfahren umfasst:
jeweiliges Erzeugen, durch mindestens einige der Anzahl von K Segmenten, einen jeweiligen Abschnitts des analogen aufwärtsgewandelten RF-Signals basierend auf einem eindeutigen Teil des seriellen Datenstroms zu erzeugen, so dass die zweite Auflösung mit der ersten Auflösung übereinstimmt;
wobei jedes Segment der Anzahl von K Segmenten mindestens ein analoges Verzögerungselement umfasst, wobei das Verfahren umfasst;
Formgeben, durch das mindestens eine analoge Verzögerungselement, des jeweiligen Abschnitts des analogen aufwärtsgewandelten RF-Signals;
wobei F_{BB} = Fₛ / N;
wobei N eine Ganzzahl ist, und N >= 1; und
wobei K eine Ganzzahl ist, und K >= 2, bevorzugt K >= 4.

## Revendications

1. Convertisseur numérique-analogique radiofréquence (RFDAC) comprenant :
un convertisseur de premier étage, configuré pour recevoir un signal numérique de bande de base et pour générer N flux de données parallèles, ayant chacun une première résolution ;
un sérialiseur, configuré pour convertir le nombre de N flux de données parallèles en un flux de données série ; et
un convertisseur de deuxième étage, configuré pour recevoir le flux de données série et générer un signal radiofréquence (RF) analogique converti à la hausse, basé sur le flux de données série, dans lequel signal RF analogique converti à la hausse a une deuxième résolution ;
dans lequel le convertisseur de premier étage est un filtre numérique à réponse impulsionnelle finie (FIR) ;
dans lequel le convertisseur de premier étage est configuré pour être piloté par un premier signal d'horloge ayant une première fréquence F_{BB} ;
dans lequel le sérialiseur est configuré pour être piloté par un deuxième signal d'horloge ayant une deuxième fréquence Fₛ ;
dans lequel le convertisseur de deuxième étage comprend un nombre de K tranches en parallèle, au moins certaines du nombre de K tranches sont configurées pour générer chacune une partie respective du signal RF analogique converti à la hausse sur la base d'une partie unique du flux de données série, de sorte que la deuxième résolution corresponde à la première résolution ;
dans lequel chaque tranche du nombre de K tranches comprend au moins un élément de retard analogique pour mettre en forme la partie respective du signal RF analogique converti à la hausse ;
dans lequel F_{BB} = Fₛ/N ;
dans lequel N est un entier, et N ≥ 1 ; et
dans lequel K est un entier, et K ≥ 2, de préférence K ≥ 4.

2. RFDAC selon la revendication 1, dans lequel N ≥ 2.

3. RFDAC selon une quelconque des revendications 1 à 2, dans lequel le convertisseur du premier étage comprend un nombre de N modules en parallèle, chacun configurés pour générer un flux de données parallèle respectif parmi le nombre de N flux de données parallèles.

4. RFDAC selon une quelconque des revendications 1 à 3, dans lequel les N flux de données parallèles comprennent des données codées par codage binaire ou thermométrique.

5. RFDAC selon une quelconque des revendications 1 à 4, dans lequel la deuxième résolution est égale ou différente de la première résolution.

6. RFDAC selon une quelconque des revendications 1 à 5, dans lequel chaque tranche du nombre de K tranches possède une valeur de pondération respective pour la mise à l'échelle d'un pas d'amplitude respectif de la partie respective du signal RF analogique converti à la hausse.

7. RFDAC selon une quelconque des revendications 1 à 6, dans lequel chaque tranche d'au moins certaines du nombre de K tranches est configurée pour générer la partie respective du signal RF analogique converti à la hausse ayant un pas d'amplitude respectif ;
dans lequel le signal RF analogique converti à la hausse est formé en combinant les sorties d'au moins certaines du nombre de K tranches.

8. RFDAC selon une quelconque des revendications 1 à 7, dans lequel au moins un élément de retard analogique est réglable ou programmable.

9. RFDAC selon une quelconque des revendications 1 à 8, dans lequel deux tranches quelconques parmi le nombre de K tranches comportent un nombre identique ou des nombres différents d'éléments de retard analogiques et dans lequel deux éléments de retard analogiques quelconques de chaque tranche sont identiques ou différents.

10. RFDAC selon la revendication 9, dans lequel une quelconque des K tranches comportant un nombre différent de cellules de retard analogiques et/ou une quelconque des K tranches comportant des éléments de retard analogiques différents sont sélectionnées aléatoirement pendant le fonctionnement.

11. RFDAC selon une quelconque des revendications 1 à 10, dans lequel chaque élément de retard analogique parmi le nombre de K tranches possède une valeur de pondération respective pour une mise à l'échelle d'amplitude.

12. RFDAC selon une quelconque des revendications 1 à 11, dans lequel chaque tranche du nombre de K tranches comprend une boucle à verrouillage de retard (DLL) comportant au moins un élément de retard analogique ;
dans lequel la boucle à verrouillage de retard est configurée pour synchroniser ladite tranche avec le deuxième signal d'horloge.

13. RFDAC selon une quelconque des revendications 1 à 12, dans lequel
chaque tranche comprend :
un convertisseur numérique-analogique à condensateur commuté (sc-DAC),
un amplificateur à condensateur commuté et
un filtre FIR analogique à maintien d'ordre zéro (ZOH).

14. Emetteur-récepteur radiofréquence, comprenant un RFDAC selon une quelconque des revendications 1 à 13, configuré pour recevoir le signal numérique de bande de base et générer le signal RF analogique converti à la hausse pour la transmission.

15. Procédé de conversion numérique-analogique, comprenant :
la réception d'un signal numérique de bande de base et la génération de N flux de données parallèles, ayant chacun une première résolution, par un convertisseur de premier étage ;
la conversion des N flux de données parallèles en un flux de données série, par un sérialiseur ; et
la réception du flux de données série et la génération d'un signal RF analogique converti à la hausse sur la base du flux de données série, par un convertisseur de deuxième étage, dans lequel le signal RF analogique converti à la hausse a une deuxième résolution ;
dans lequel le convertisseur de premier étage est un filtre numérique à réponse impulsionnelle finie (FIR) ;
dans lequel le convertisseur de premier étage est configuré pour être piloté par un premier signal d'horloge ayant une première fréquence F_{BB} ;
dans lequel le sérialiseur est configuré pour être piloté par un deuxième signal d'horloge ayant une deuxième fréquence Fₛ ;
dans lequel le convertisseur de deuxième étage comprend un nombre de K tranches en parallèle, le procédé comprenant :
au moins certaines du nombre de K tranches générant chacune une partie respective du signal RF analogique converti à la hausse sur la base d'une partie unique du flux de données série, de sorte que la deuxième résolution corresponde à la première résolution ;
dans lequel chaque tranche du nombre de K tranches comprend au moins un élément de retard analogique, le procédé comprenant :
le au moins un élément de retard analogique mettant en forme la partie respective du signal RF analogique converti à la hausse ;
dans lequel F_{BB} = Fₛ/N ;
dans lequel N est un entier, et N ≥ 1 ; et
dans lequel K est un entier, et K ≥ 2, de préférence K ≥ 4.
